# EUROPEAN PATENT APPLICATION

(11) **EP 3 848 956 A1**
(43) Date of publication of application: **14.07.2021**
(21) Application number: 19857666.2
(22) Date of filing: 24.06.2019
(51) Int. Cl.: H01L 21/28

(54) **SEMICONDUCTOR MANUFACTURE METHOD AND SEMICONDUCTOR MANUFACTURE DEVICE**

(30) Priority: 07.09.2018 JP 2018168229
(71) Applicant: Sumitomo Heavy Industries, Ltd., Tokyo 141-6025 (JP)
(72) Inventor: KAWASAKI, Teruhisa, Yokosuka-shi, Kanagawa 237-8555 (JP); AOYAGI, Yoshinobu, Kusatsu-shi, Shiga 525-8577 (JP); KUROSE, Noriko, Kusatsu-shi, Shiga 525-8577 (JP)
(74) Representative: Louis Pöhlau Lohrentz
(86) International application number: PCT/JP2019/024914
(87) International publication number: WO 2020/049835

(57) **Abstract**

Provided is a technique for optimally performing annealing of an electrode. A semiconductor manufacturing method includes a metal thin film deposition step of depositing a metal thin film 161 on a p-type GaN substrate 11, and a laser beam irradiation step of irradiating the deposited metal thin film 161 with a laser beam. As the metal thin film 161 is irradiated with the laser beam while avoiding irradiation of other portions on the p-type GaN substrate 11 with the laser beam, it is possible to suppress heating and an increase in temperature of other portions and to primarily anneal the metal thin film 161. Accordingly, optimization of the annealing of the electrode is achieved.

## Description

### Technical Field

The present invention relates to a semiconductor manufacturing method and a semiconductor manufacturing device.

### Background Art

A nitride semiconductor represented by AlN, AlGaN, GaN, InGaN, or InN has a wide band gap compared to silicon, and is advanced in application to a high frequency and high output transistor or the like that is operable even under a high temperature environment. With this, a significant reduction in size or high efficiency of equipment is expected.

For such a wide band gap semiconductor, in a manufacturing process, an entire substrate is annealed at a predetermined temperature by an annealing device (RTA) to form an ohmic electrode, thereby achieving improvement in ohmic characteristics (for example, see PTL 1).

### Citation List

### Patent Literature

[PTL 1] Japanese Unexamined Patent Publication No. H10-135515

### Summary of Invention

### Technical Problem

However, in the related art, the entire substrate is heated in a chamber of the annealing device. For this reason, heating also has an influence on portions other than the ohmic electrode, and there is a problem in that damage to characteristics as a semiconductor, such as high resistance due to the influence of heat, occurs, and electrical characteristics of the wide band gap semiconductor may not be utilized.

An object of the invention is to efficiently form an ohmic electrode by performing laser annealing locally.

### Solution to Problem

A semiconductor manufacturing method according to the invention includes
a metal thin film deposition step of depositing a metal thin film on a donor or acceptor-doped nitride semiconductor; and
a laser beam irradiation step of irradiating the deposited metal thin film with a laser beam.

A semiconductor manufacturing device according to the invention includes
a metal thin film deposition unit that deposits a metal thin film on a donor or acceptor-doped nitride semiconductor; and
a laser beam irradiation unit that irradiates the metal thin film deposited by the metal thin film deposition unit with a laser beam.

### Advantageous Effects of Invention

According to the invention, it is possible to locally heat a metal thin film deposition portion (ohmic electrode) on a substrate, and to suppress an influence of heating on portions other than the ohmic electrode.

### Brief Description of Drawings

Fig. 1 is a cross-sectional view regarding a semiconductor using a donor or acceptor-doped nitride semiconductor that is an embodiment according to the invention.
Fig. 2 is a schematic configuration diagram of an electron beam deposition device of a semiconductor manufacturing device.
Fig. 3 is a schematic configuration diagram of a laser machining device of the semiconductor manufacturing device.
Fig. 4A is an explanatory view showing a manufacturing method of a semiconductor.
Fig. 4B is an explanatory view showing the manufacturing method of the semiconductor subsequent to Fig. 4A.
Fig. 4C is an explanatory view showing the manufacturing method of the semiconductor subsequent to Fig. 4B.
Fig. 4D is an explanatory view showing the manufacturing method of the semiconductor subsequent to Fig. 4C.
Fig. 4E is an explanatory view showing the manufacturing method of the semiconductor subsequent to Fig. 4D.
Fig. 4F is an explanatory view showing the manufacturing method of the semiconductor subsequent to Fig. 4E.
Fig. 5 is a plan view of a mask member for laser.
Fig. 6 is an explanatory view showing a configuration for measuring an I-V characteristic of a sample where an electrode is subjected to laser annealing.
Fig. 7 is a diagram showing I-V characteristics of four samples where an electrode is subjected to laser annealing.

### Description of Embodiments

Hereinafter, respective embodiments of the invention will be described in detail referring to the drawings. In the embodiment, a semiconductor manufacturing method and a semiconductor manufacturing device for a semiconductor using a donor or acceptor-doped nitride semiconductor will be described.

### [Semiconductor]

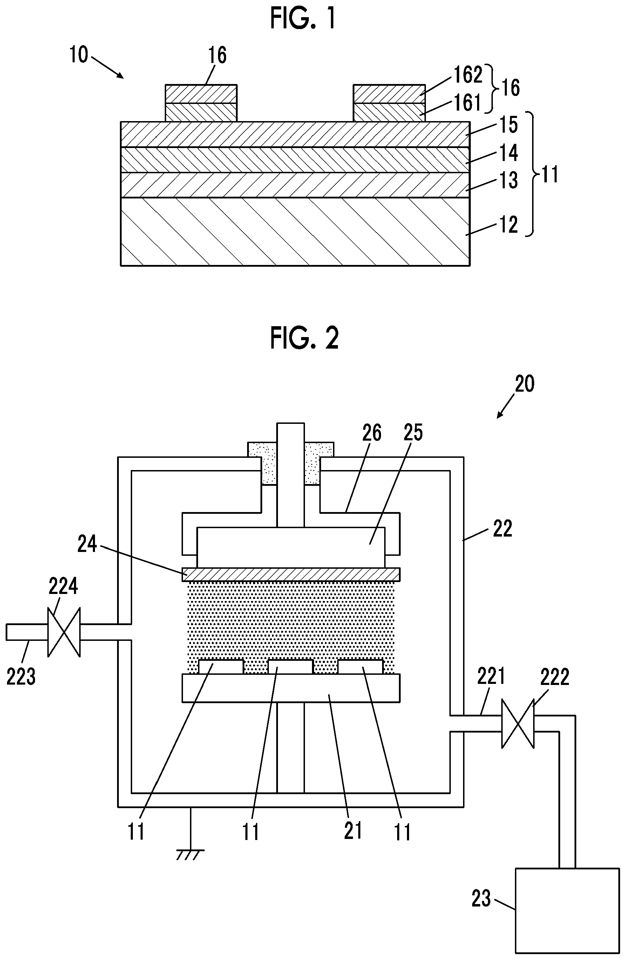

Hereinafter, the invention will be specifically described. Fig. 1 is a cross-sectional view regarding a semiconductor 10 using a p-type GaN substrate that is an embodiment according to the invention.

The semiconductor 10 includes a p-type GaN substrate 11, and an electrode 16 made of a metal thin film formed on the p-type GaN substrate 11.

The semiconductor 10 shown herein is merely an example of a semiconductor using a p-type GaN substrate, and the invention can be applied to a variety of semiconductors using a donor or acceptor-doped nitride semiconductor.

In the p-type GaN substrate 11, as shown in the drawing, a low-temperature (LT) -GaN layer 13 is formed on an upper surface of a substrate 12, and a high-temperature (HT)-GaN layer 14 is formed on an upper surface of the LT-GaN layer 13. In addition, the p-type GaN substrate 11 has a configuration in which a GaN layer 15 as a nitride semiconductor layer is formed on an upper surface of the HT-GaN layer 14.

The substrate 12 is not particularly limited and may be made of any crystal as long as a nitride semiconductor layer can be formed on a surface of the substrate 12, and for example, a silicon (Si) substrate, a sapphire substrate, a SiC substrate, and a GaN substrate, and the like can be used. Here, a sapphire substrate is exemplified. A thickness of the substrate 12 may be a normal thickness (about 100 to 1000 [µm]) in a field of semiconductor technology, and is not particularly limited.

The LT-GaN layer 13 is a buffer layer that is laminated at a lower temperature than the HT-GaN layer 14 and the GaN layer 15 to relax lattice mismatch. The buffer layer may be a layer that is generally used in a field of semiconductor technology.

The HT-GaN layer 14 is laminated and formed at a higher temperature than the LT-GaN layer 13. As the HT-GaN layer 14, a next generation semiconductor material is laminated.

The GaN layer 15 is made of additive-doped GaN in which any of AlGaN, indium gallium nitride (InGaN) , and aluminum indium gallium nitride (AlInGaN), which is mixed crystal obtained by mixing GaN or GaN and AlN at a predetermined ratio, is doped with an impurity. The impurity-doped GaN may be any of p-type GaN where GaN is doped with a p-type impurity and n-type GaN where GaN is doped with an n-type impurity. Here, a GaN layer made of p-type GaN is exemplified.

The GaN layer 15 made of p-type GaN is doped with Mg as an impurity. It is desirable that a doping amount of Mg is within a range equal to or greater than 1.0E+17 and equal to or smaller than 6.0E+19 [cm⁻³] .

Furthermore, a thickness of the GaN layer 15 is equal to or greater than two times, more desirably, five times, a thickness of a lower electrode 161 of the electrode 16 formed on the GaN layer 15.

Note that, in a case where the GaN layer 15 consists of n-type GaN, Si is doped as an impurity.

On an upper surface of the GaN layer 15, a plurality of electrodes 16 (in Fig. 1, only two electrodes are shown) are formed at predetermined intervals.

The electrodes 16 are formed to cover only a portion of one surface of the GaN layer 15, which is a semiconductor layer, without covering the whole of one surface. Then, all electrodes 16 are formed on one surface side of the GaN layer 15 that is a semiconductor layer.

Such electrodes 16 are formed as ohmic electrodes showing ohmic characteristics. Examples of a metal material used for such electrodes include gold (Au), titanium (Ti), nickel (Ni), aluminum (Al), vanadium (V), and molybdenum (Mo). Alternatively, such metal materials may be laminated in a plurality of combinations to form electrodes.

Here, a case where the electrode 16 consists of a laminated electrode where the lower electrode 161 on the GaN layer 15 side is formed of Ni and an upper electrode 162 laminated on the lower electrode 161 is formed of Au is exemplified. For example, as the upper electrode 162 is formed of Au, it is possible to protect the lower electrode 161 made of Ni from oxidation or the like.

Furthermore, it is desirable that the lower electrode 161 has a film thickness equal to or greater than 5 nm and less than 30 nm. In regard to the lower electrode 161, while ohmic junction is achieved by laser annealing described below, the thickness is set within the range, whereby heating by laser is effectively performed and satisfactory ohmic contact is realized.

### [Semiconductor Manufacturing Device]

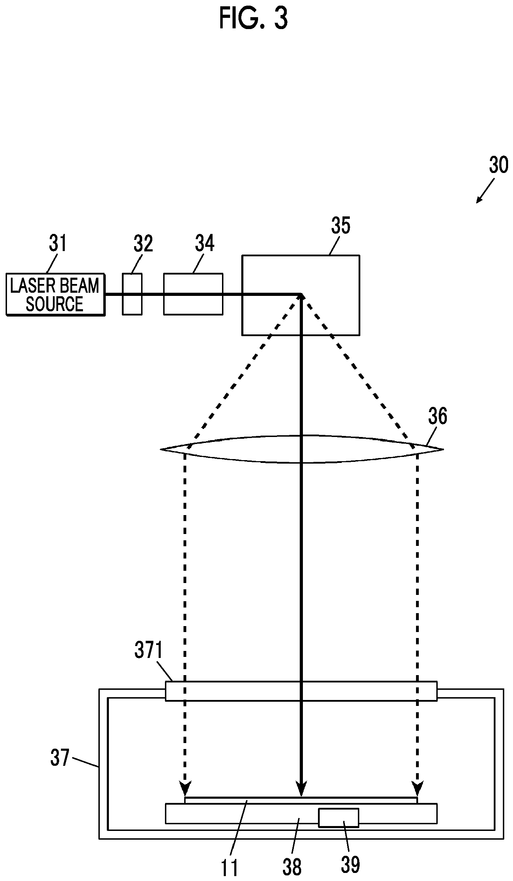

A semiconductor manufacturing device is a semiconductor manufacturing device suitable for manufacturing the semiconductor 10 described above, and primarily includes an electron beam deposition device 20 (see Fig. 2) and a laser machining device 30 (see Fig. 3).

The electron beam deposition device 20 functions as a metal thin film deposition unit that deposits the electrode 16 as a metal thin film on the p-type GaN substrate 11.

Furthermore, the laser machining device 30 functions as a laser beam irradiation unit that irradiates the electrode 16 made of the metal thin film deposited by the electron beam deposition device 20 with a laser beam.

### [Semiconductor Manufacturing Device: Electron Beam Deposition Device]

Fig. 2 is a schematic configuration diagram of the electron beam deposition device 20.

As shown in the drawing, the electron beam deposition device 20 includes a stage 21 on which the p-type GaN substrate 11 of the semiconductor 10 is installed, a chamber 22 that stores the stage 21, a cryopump 23 that is connected to an exhaust port 221 of the chamber 22 through a valve 222, a target 24 that is made of a material for forming a metal thin film provided to face the stage 21 at a given interval, a cathode electrode 25 that applies a voltage to a surface opposite to a surface of the target 24 facing the stage 21, and a cathode shield 26 that supports the cathode electrode 25.

The chamber 22 can cut off outside air to bring an inside into an airtight state. Then, the chamber 22 is provided with a gas introduction port 223 and a valve 224 configured to introduce gas, which generates plasma, in addition to the above-described exhaust port 221 that exhausts inside gas.

Inert gas (for example, Ar gas) is supplied from the gas introduction port 223 into the chamber 22.

In the chamber 22, the stage 21 is grounded. Then, a predetermined voltage can be applied to the target 24 facing the stage 21 by the cathode electrode 25. With this, in a case where discharge is generated between the target 24 and the p-type GaN substrate 11 in a state in which inert gas is supplied into the chamber 22, particles made of a target material can be attached to the p-type GaN substrate 11 to be deposited.

Note that a permanent magnet or an electromagnet may be disposed on a rear surface side (cathode electrode 25) of the target 24 to perform deposition.

### [Semiconductor Manufacturing Device: Laser Machining Device]

Fig. 3 is a schematic configuration diagram of the laser machining device 30.

The laser machining device 30 is a laser annealing device that has the electrode 16 of the semiconductor 10 as a machining subject and irradiates the electrode 16 with a laser beam to perform annealing processing.

The laser machining device 30 includes a laser beam source 31, an attenuator 32, a beam homogenizer 34, a beam scanner 35, a lens 36, a chamber 37, a stage 38, and a photodetector 39.

The laser beam source 31 outputs a pulsed laser beam in an ultraviolet range. For example, the laser beam source 31 can output the pulsed laser beam with a pulse width within a range equal to or greater than 1 [ns] and less than 1000 [ns]. That is, the laser beam source 31 that outputs pulsed laser beam having a desired pulse width within the above-described range is used.

For the laser beam source 31, for example, a Nd:YVO4 laser oscillator that outputs third harmonics having a wavelength of 355 [nm] is used. In addition, a Nd:YLF laser oscillator or a Nd:YAG laser oscillator may be used.

The p-type GaN substrate 11 on which the lower electrode 161 is formed can be placed on the stage 38.

The chamber 37 stores the stage 38 inside and can cut off outside air to bring the inside into an airtight state.

The chamber 37 is provided with a laser transmission window 371, and can introduce the laser beam from the laser beam source 31 onto the stage 38 inside.

The lens 36 and the laser transmission window 371 are optical parts that are disposed on a path of the pulsed laser beam scanned by the beam scanner 35. The laser transmission window 371 has a structure in which an antireflection film is coated on a surface of a synthetic quartz plate, for example.

Furthermore, the chamber 37 is provided with an introduction port and an exhaust port (not shown) of oxygen or inert gas (argon, nitrogen, or the like), and can be made into an oxygen atmosphere, air atmosphere, inert atmosphere, or vacuum during laser annealing. Note that a supply source and an exhaust pump of oxygen or inert gas are omitted in the drawing.

The attenuator 32 changes an attenuation factor of the pulsed laser beam based on a command from a controller (not shown) of the semiconductor manufacturing device.

The beam homogenizer 34 homogenizes a beam profile on the surface of the p-type GaN substrate 11.

The beam scanner 35 scans the pulsed laser beam in a two-dimensional direction based on a scanning command from the controller (not shown) of the semiconductor manufacturing device. For the beam scanner 35, for example, a galvanoscanner having a pair of movable mirrors can be used.

The lens 36 consists of, for example, an fθ lens, and realizes a substantially image side telecentric optical system. A movement speed of an incidence position of the pulsed laser beam scanned by the beam scanner 35 on the surface of the electrode 16 of the semiconductor 10 is, for example, 200 [mm/s].

In the chamber 37, the photodetector 39 is disposed. The pulsed laser beam can be made to be incident on the photodetector 39 by controlling the beam scanner 35. In this state, the photodetector 39 can measure light intensity of the pulsed laser beam, for example, average power or pulse energy. The photodetector 39 inputs a measurement result to the controller (not shown), and the controller can confirm the normality of the laser beam source 31, the attenuator 32, and the beam homogenizer 34 based on the measurement result. In addition, the presence or absence of dirt or deterioration of the lens 36 and the laser transmission window 371 at a place where the pulsed laser beam is transmitted can be confirmed.

### [Manufacturing Method of Semiconductor]

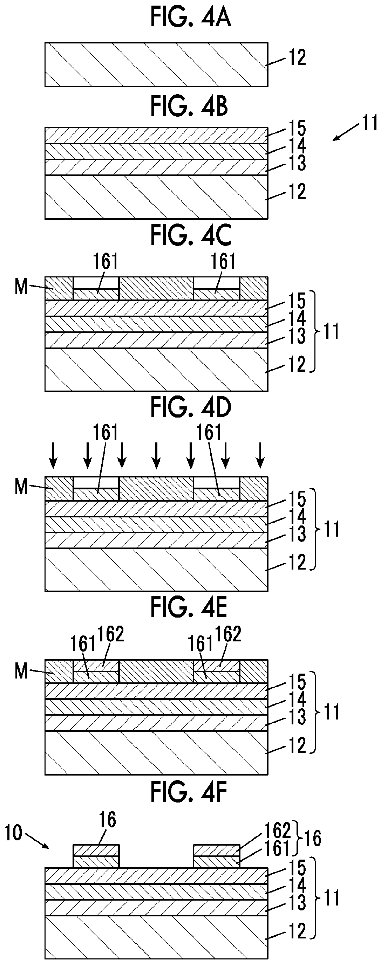

Figs. 4A to 4F are explanatory views showing a manufacturing method of the semiconductor 10 in order.

As shown in Fig. 4A, first, the substrate 12 made of a sapphire substrate having a thickness of 0.43 [µm] is prepared.

Next, as shown in Fig. 4B, the LT-GaN layer 13, the HT-GaN layer 14, and the GaN layer 15 are formed on the substrate 12 in order (semiconductor layer forming step). In forming the respective layers, vapor phase epitaxy, such as metal organic vapor phase epitaxy (MOCVD), hydride vapor phase epitaxy (HVPE), molecular beam epitaxy (MBE), or pulsed laser deposition (PLD), can be used.

Next, as shown in Fig. 4C, the lower electrode 161 of the electrode 16 made of a metal thin film is formed using the electron beam deposition device 20 (metal thin film deposition step) . Note that, prior to forming the lower electrode 161, the GaN layer 15 of the p-type GaN substrate 11 is sufficiently cleaned by organic cleaning, SPM cleaning, acid cleaning, or pure water cleaning, and is sufficiently dried.

An electrode, such as the lower electrode 161, can be formed by deposition with Ni as the target 24 using the electron beam deposition device 20 after application of a photoresist to the upper surface of the GaN layer 15, exposure and development of the photoresist with a photomask in which a desired electrode pattern is formed, removal of the photoresist in a region where an electrode is formed, and cleaning.

Alternatively, the lower electrode 161 may be formed using a mask member M for laser that is used in laser annealing, instead of a photoresist.

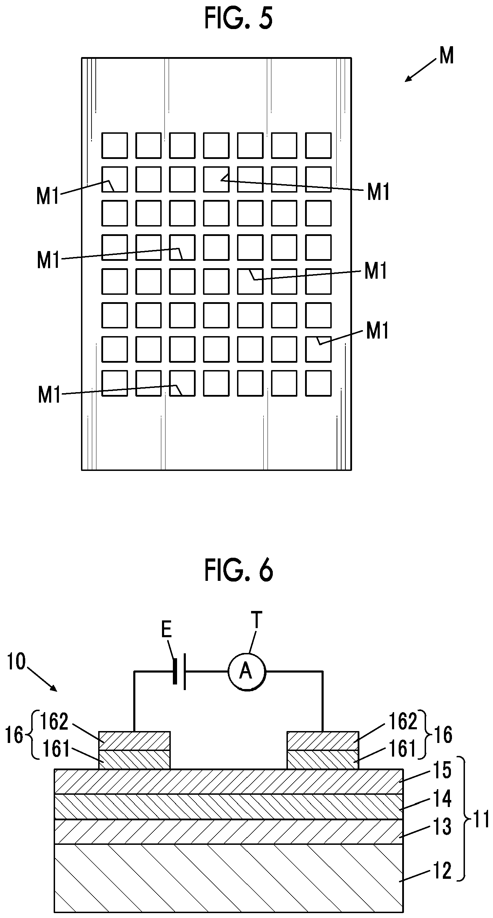

The mask member M for laser is a flat plate made of a material (stainless steel, nickel alloy, or the like) having a predetermined thickness that bears irradiation of the laser beam. As shown in Fig. 5, the mask member M for laser has openings M1 corresponding to a forming pattern of an electrode.

Then, as shown in Fig. 4C, the mask member M for laser is closely attached to an electrode forming surface side of the GaN layer 15 of the p-type GaN substrate 11, and is installed on the stage 21 in the chamber 22 of the electron beam deposition device 20. Then, the target 24 made of Ni is mounted to face the stage 21, and the chamber 22 is deaerated and filled with inert gas. In addition, a voltage is applied to the target 24, and Ni is deposited on the surface of the GaN layer 15 viewed from the mask member M for laser and the openings M1 by electron beam deposition.

With this, the lower electrode 161 is formed on the electrode forming surface of the GaN layer 15 according to the forming pattern of the electrode.

Next, as shown in Fig. 4D, laser annealing of the lower electrode 161 by the laser machining device 30 is performed (laser beam irradiation step).

The p-type GaN substrate 11 on which the lower electrode 161 is formed is installed on the stage 38 in the chamber 37 of the laser machining device 30 along with the mask member M for laser.

The inside of the chamber 37 is maintained in an air atmosphere state.

The pulsed laser beam having a pulse width within a range equal to or greater than 1 ns and less than 1000 ns is output from the laser beam source 31.

The irradiation energy of the laser beam is controlled by the attenuator 32 such that the lower electrode 161 is not melted, and an interface temperature of the lower electrode 161 and the p-type GaN substrate 11 is equal to or lower than 800°C. Furthermore, the interface temperature is set to be at least equal to or higher than 300°.

In addition, under the control of the beam scanner 35, the irradiation of the pulsed laser beam is performed in a two-dimensional manner of a main scanning direction and a sub-scanning direction, and the irradiation of the pulsed laser beam is performed such that the whole of the electrode forming surface of the GaN layer 15 of the p-type GaN substrate 11 is within an irradiation range. With this, the irradiation of the pulsed laser beam is performed from each opening M1 to each lower electrode 161, and the irradiation of the remaining pulsed laser beam is performed to the mask member M for laser.

With the laser annealing, satisfactory ohmic contact of the lower electrode 161 with the p-type GaN substrate 11 is realized.

Next, as shown in Fig. 4E, the upper electrode 162 of the electrode 16 made of a metal thin film is formed using the electron beam deposition device 20 again (Au deposition step).

The upper electrode 162 can also be formed by application of a photoresist to the upper surface of the GaN layer 15, exposure and development of the photoresist with a photomask in which a desired electrode pattern is formed, removal of the photoresist in a region where an electrode is formed, cleaning, and film formation with Au as the target 24 using the electron beam deposition device 20 while removing the mask member M for laser.

Furthermore, instead of the photoresist, the upper electrode can be formed by film formation with Au as the target 24 using the electron beam deposition device 20 in a state in which the mask member M for laser is mounted.

Then, as shown in Fig. 4F, after the upper electrode 162 is formed, the mask member M for laser is detached, and the formation of the electrode 16 on the p-type GaN substrate 11 is completed.

### [Technical Effects according to Embodiment of the Invention]

In the above-described semiconductor manufacturing method, the lower electrode 161 of the electrode 16 deposited by the laser beam irradiation step is irradiated with the laser beam to perform laser annealing, and thus, it becomes easy to selectively heat only the lower electrode 161 of the p-type GaN substrate 11, and it is possible to achieve satisfactory ohmic junction of the lower electrode 161.

In addition, it is possible to suppress heating portions other than the lower electrode 161, and to minimize an influence of heating on the portions other than the lower electrode 161 in the p-type GaN substrate 11. In particular, in a case where configurations other than the lower electrode 161 are already formed on the p-type GaN substrate 11, it is possible to particularly effectively suppress an influence of heating on other configurations.

The semiconductor manufacturing device includes the electron beam deposition device 20 that deposits the metal thin film, and the laser machining device 30 that irradiates the lower electrode 161 made of the metal thin film with the laser beam. For this reason, it is possible to provide a semiconductor manufacturing device that effectively suppresses the influence of heating on the configurations other than the lower electrode 161 while achieving satisfactory ohmic junction of the lower electrode 161.

In the semiconductor manufacturing method, the upper electrode 162 made of Au is deposited on the lower electrode 161 after the laser beam irradiation step, and thus, it is possible to effectively perform laser annealing to the lower electrode while preventing the laser beam from being reflected by the upper electrode 162.

The laser beam by the laser machining device 30 is pulsed laser, and irradiation of the laser beam is performed with a pulse width equal to or greater than 1 ns and less than 1000 ns. With this, it is possible to suppress and control a heat influence in a substrate depth direction.

The irradiation energy of the laser beam by the laser machining device 30 is set within a range in which the lower electrode 161 is not melted, and the interface temperature of the lower electrode 161 and the GaN layer 15 is equal to or lower than 800°C. With this, it is possible to avoid melting of the lower electrode 161, to suppress a shortage of nitrogen of the p-type GaN substrate 11, and to achieve satisfactory ohmic junction of the lower electrode 161.

The lower electrode 161 is formed to have a thickness smaller than 30 nm and equal to or greater than 5 nm. As the thickness is set within the range, the lower electrode 161 is effectively heated by laser, and satisfactory ohmic contact is realized.

### [Example]

An example of the invention will be described.

The GaN layer 15 of the semiconductor 10 shown in the example is made of Mg-doped p-type GaN, and a doping amount of Mg is 1.6×10¹⁸ [cm⁻³]. A sapphire substrate was used for the substrate 12, and the GaN layer 15 was formed by a MOCVD device.

The substrate 12 of the p-type GaN substrate 11 was formed to have a thickness of 430 [µm], the LT-GaN layer 13 was formed to have a thickness of 0.02 [µm], the HT-GaN layer 14 was formed to have a thickness of 0.96 [µm], and the GaN layer 15 was formed to have a thickness of 1.0 [µm].

A plurality of lower electrodes 161 were made of Ni, and were formed to have a thickness of 20 [nm] by the electron beam deposition device 20. The respective lower electrodes 161 were formed with a width in an arrangement direction of 1 [mm], and the respective lower electrodes 161 were formed at an interval in the arrangement direction of 5 to 500 [µm], and specifically, 500 [µm].

Laser annealing was performed on the p-type GaN substrate 11, on which the lower electrodes 161 were formed, by the laser machining device 30.

The laser beam source 31 output pulsed laser of third harmonics having a wavelength of 355 [nm], and scanned the pulsed laser with a pulse width of 40 [ns], a frequency of 20 [kHz], and a speed of 200 [mm/s] . An overlap ratio was 80%/80%. The overlap ratio indicates a proportion of overlap of beam spots of laser output in a pulsed manner in the main scanning direction and the sub-scanning direction.

The above-described laser annealing was performed at a normal temperature in a state in which the chamber 37 was made into an oxygen atmosphere of a concentration of 20%.

Under the above-described machining conditions, four samples where laser annealing was performed with laser energy density of 0.5, 1.0, 1.5, and 2.0 [J/cm²], respectively, were prepared.

In the respective samples, after the laser annealing, the upper electrode 162 made of Au was formed to have a thickness of 40 [µm] on the lower electrode 161.

In regards to the four samples, as shown in Fig. 6, a direct current power supply E was connected to two electrodes 16, and a current flowing in the two electrodes 16 was measured by an ammeter T to measure I-V characteristics of the respective samples.

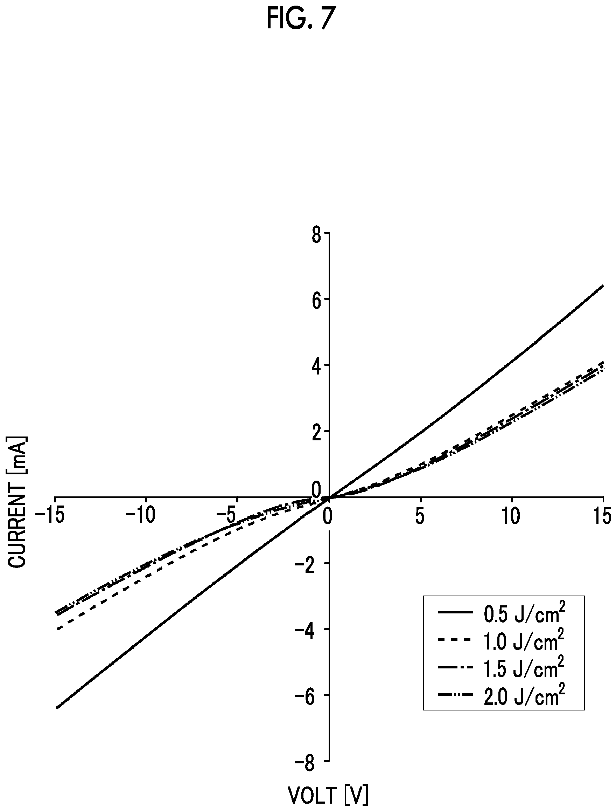

Fig. 7 is a diagram showing the I-V characteristics of the four samples where laser annealing is performed with 0.5, 1.0, 1.5, and 2.0 [J/cm²]. The vertical axis indicates a voltage, and the horizontal axis indicates a current.

As a result, a characteristic of Schottky contact was indicated in three samples where laser annealing was performed with 1.0, 1.5, and 2.0 [J/cm²], and a characteristic of satisfactory ohmic contact was obtained in a sample where laser annealing is performed with 0.5 [J/cm²]. In this sample, it was confirmed by an optical microscope that a surface state after laser irradiation was not melted.

### [Others]

The embodiment of the invention has been described above. However, the invention is not limited to the above-described embodiment, and suitable changes can be made in the details described in the embodiment without departing from the concept of the invention.

For example, the semiconductor 10 may have a configuration in which an electrode is provided on one surface of a GaN layer, and suitable change can be made in other configurations.

Alternatively, in the laser machining device 30, although a configuration for irradiation of pulsed laser has been made, the invention is not limited thereto, and for example, a configuration for irradiation of CW laser may be made.

Furthermore, in a case where laser annealing is performed on the lower electrode 161, the mask member M for laser may not be used, two-dimensional data of an electrode pattern for forming the lower electrode 161 may be prepared in the controller of the semiconductor machining device, and control may be performed such that the beam scanner 35 irradiates only a forming position of the lower electrode 161 with the laser beam.

For the metal thin film deposition unit of the semiconductor machining device, a diode sputtering type or magnetron sputtering type sputtering device or an ion beam type sputtering device may be employed.

In addition, for the metal thin film deposition unit, a vacuum deposition type, molecular beam deposition type, ion plating type, or ion beam deposition type deposition device may be employed.

The term "deposition" in the embodiment and the claims is a concept including both sputtering by various sputtering devices described above and deposition for attaching a target metal evaporated and vaporized by heating to a substrate.

### Industrial Applicability

The semiconductor manufacturing method and the semiconductor manufacturing device according to the invention have industrial applicability in heating a nitride semiconductor.

### Reference Signs List

10 semiconductor
11 p-type GaN substrate
12 substrate
15 GaN layer
16 electrode
161 lower electrode (metal thin film)
162 upper electrode (metal thin film)
20 electron beam deposition device(metal thin film deposition unit, Au deposition unit)
30 laser machining device(laser beam irradiation unit)
31 laser beam source
32 attenuator
34 beam homogenizer
35 beam scanner
M mask member for laser

## Claims

1. A semiconductor manufacturing method comprising:
a metal thin film deposition step of depositing a metal thin film on a donor or acceptor-doped nitride semiconductor; and
a laser beam irradiation step of irradiating the deposited metal thin film with a laser beam.

2. The semiconductor manufacturing method according to claim 1, further comprising:
an Au deposition step of depositing Au on the metal thin film after the laser beam irradiation step.

3. The semiconductor manufacturing method according to claim 1 or 2,
wherein the laser beam is pulsed laser and has a pulse width equal to or greater than 1 ns and less than 1000 ns.

4. The semiconductor manufacturing method according to any one of claims 1 to 3,
wherein irradiation energy of the laser beam is set such that the metal thin film is not melted, and an interface temperature of the metal thin film and the nitride semiconductor is equal to or lower than 800°C.

5. The semiconductor manufacturing method according to any one of claims 1 to 4,
wherein the metal thin film has a thickness smaller than 30 nm and equal to or greater than 5 nm.

6. A semiconductor manufacturing device comprising:
a metal thin film deposition unit that deposits a metal thin film on a donor or acceptor-doped nitride semiconductor; and
a laser beam irradiation unit that irradiates the metal thin film deposited by the metal thin film deposition unit with a laser beam.

7. The semiconductor manufacturing device according to claim 6, further comprising:
an Au deposition unit that deposits Au on the metal thin film.

8. The semiconductor manufacturing device according to claim 6 or 7,
wherein the laser beam of the laser beam irradiation unit is pulsed laser and has a pulse width equal to or greater than 1 ns and less than 1000 ns.

9. The semiconductor manufacturing device according to any one of claims 6 to 8,
wherein the laser beam irradiation unit sets irradiation energy of the laser beam such that the metal thin film is not melted, and an interface temperature of the metal thin film and the nitride semiconductor is equal to or lower than 800°C.
